(19) Europäisches Patentamt / European Patent Office / Office européen des brevets

(11) **EP 2 264 473 B1**

(12) **FASCICULE DE BREVET EUROPEEN**

(45) Date de publication et mention de la délivrance du brevet:
**10.02.2016 Bulletin 2016/06**

(51) Int Cl.:
***G01R 31/28*** *(2006.01)*

(21) Numéro de dépôt: **10166521.4**

(22) Date de dépôt: **18.06.2010**

(54) **Procédé et système d'adaptation optimale d'impédance de source en entrée de composants électroniques, en particulier de transistors**

Verfahren und System zur optimalen Adaptation der Quellenimpedanz am Eingang elektronischer Komponenten, insbesondere an Transistoren

Method and system for optimal adjustment of the impedance of an input source of electronic components, in particular of transistors

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **18.06.2009 FR 0902961**

(43) Date de publication de la demande:
**22.12.2010 Bulletin 2010/51**

(73) Titulaire: **AMCAD Engineering**
**87068 Limoges (FR)**

(72) Inventeur: **Gasseling, Tony**
**23300, LA SOUTERRAINE (FR)**

(74) Mandataire: **Novagraaf Technologies**
**Bâtiment O2**
**2, rue Sarah Bernhardt**
**CS90017**
**92665 Asnières-sur-Seine Cedex (FR)**

(56) Documents cités:
**WO-A-2005/121817**

- BIONDI T ET AL: "Large-signal source/load-pull verification of an ST-SPICE gummel-poon model for RF silicon power bipolar transistors" ELECTRON DEVICES FOR MICROWAVE AND OPTOELECTRONIC APPLICATIONS, 2002. EDMO 2002. THE 10TH IEEE INTERNATIONAL SYMPOSIUM ON 18-19 NOV. 2002, PISCATAWAY, NJ, USA, IEEE, 18 novembre 2002 (2002-11-18), pages 196-201, XP010625952 ISBN: 978-0-7803-7530-7

**Description**

L'invention se rapporte à un procédé d'adaptation optimale d'impédance de source en entrée de composants électroniques, en particulier de transistors.

Les composants électroniques de type transistors sont employés dans les circuits électroniques radiofréquences (RF) et hyperfréquences (HF) pour amplifier la puissance d'un signal d'entrée.

Ces composants sont *a priori* désadaptés en impédance. En conséquence, si aucune attention particulière n'est portée sur les conditions d'introduction de ces composants dans un circuit électronique donné, la majorité du signal incident est réfléchi au niveau de l'entrée du composant. Ce signal ne sera donc pas amplifié.

Par conséquent, il est nécessaire d'adapter l'entrée de ce composant en impédance. Cela passe notamment par des circuits d'adaptation ou tuners. Ces tuners permettent de diminuer la quantité de signal réfléchi en entrée, et donc de maximiser la quantité de signal entrante dans le composant, qui sera amplifiée par la suite. Un tuner est un transformateur qui effectue une transition entre l'impédance caractéristique de sortie du circuit électronique délivrant le signal au composant et l'impédance d'entrée dudit composant.

Un transfert maximisé de signal passe donc par une connaissance préalable de ces deux impédances. Une telle maximisation fait intervenir les notions de gain transducique et de gain en puissance du dispositif sous test, nommé ci-après DST. Le gain en puissance est le ratio entre la puissance de sortie délivrée à la charge et la puissance nette injectée en entrée dans le DST. Le gain transducique est le ratio entre la puissance de sortie délivrée à la charge et la puissance brute disponible en entrée du DST en provenance de la source. Ainsi, le gain en puissance correspond au gain transducique quand le transfert de puissance en entrée est maximal, à savoir quand l'adaptation d'impédance est réalisée entre le DST et la source. Toute la puissance disponible de la source est transférée et injectée dans le DST.

La connaissance des impédances est atteinte à partir de mesures de puissance généralement effectuées par des bolomètres connectés au circuit par l'intermédiaire de coupleurs de mesures Pour avoir accès à ces informations, les bancs de mesures utilisés mettent en oeuvre des tuners d'impédances d'entrée et de sortie du DST, et des coupleurs d'entrée soit en amont soit en aval du tuner d'entrée.

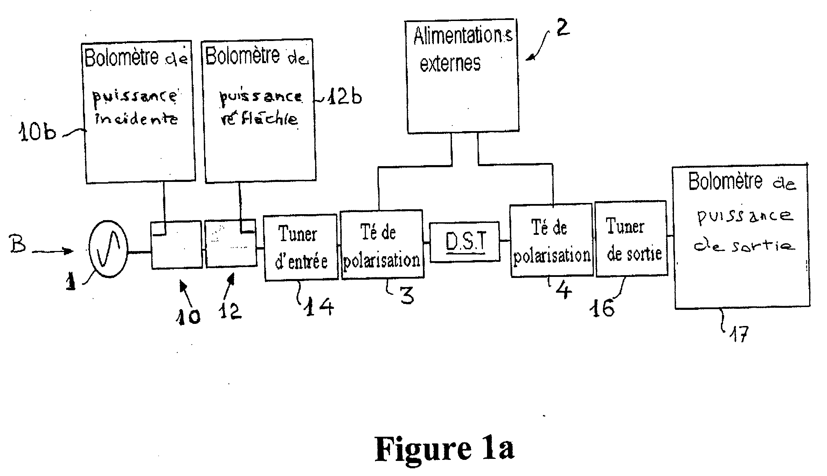

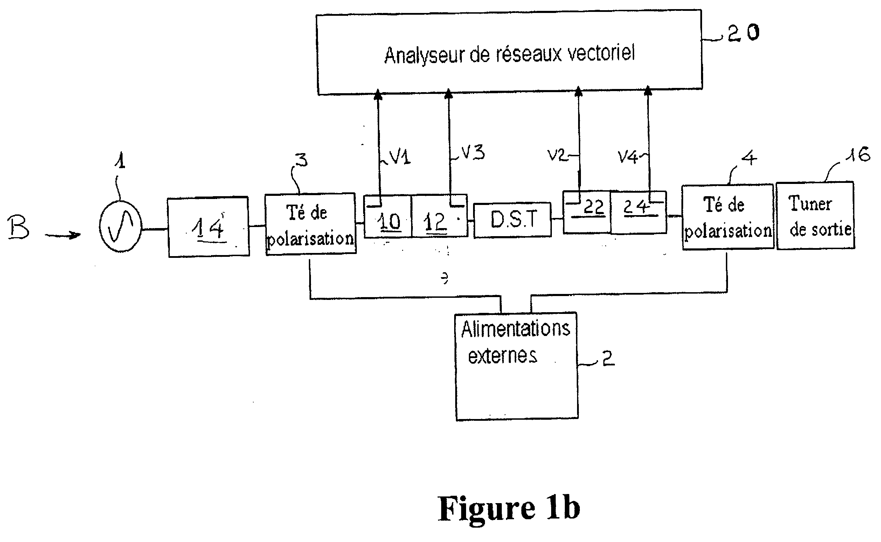

La technique de référence générale, dite de « source pull » / « load pull » (provenant de la source / provenant de la charge) et illustrée respectivement en Figures 1a et 1b, fait intervenir des coupleurs d'entrée , 10 et 12, pour la mesure des signaux incidents et réfléchis en entrée du DST (ici un transistor), respectivement en configuration amont et avale du tuner d'entrée 14 dans un banc de mesure B. Une alimentation externe 2 permet d'alimenter en courant et en tension via des Tés de polarisation, 3 et 4, de part et d'autre du DST lorsque le DST ne possède pas de circuits de polarisation interne (ce qui est le cas pour un transistor). Les mêmes références désignent les mêmes éléments des Figures 1 a et 1 b. De telles techniques sont décrites par exemple dans les documents de brevet US 7248866 , CA 2558861 ou CA 2549698.

En référence à la Figure 1a, le tuner d'entrée 14 fait varier l'impédance présentée par la source 1 à l'entrée du DST. Cette impédance est alors ajustée par réglage d'une impédance de source optimale en entrée du DST pour minimiser la puissance réfléchie et donc maximiser le gain en puissance transducique. L'optimisation est obtenue à partir des ratios de mesures de puissances réfléchies, effectuées par un bolomètre 12b connecté au coupleur d'entrée 12 mesurant le signal réfléchi, rapportées aux mesures de puissances incidentes effectuées par un bolomètre 10b connecté au coupleur 10 mesurant le signal incident.

En mesure « load pull », la technique est appliquée de manière semblable en sortie : elle consiste à faire varier l'impédance de charge présentée en sortie du DST au moyen d'un tuner de sortie 16. L'impédance de charge est alors optimisée à l'aide du tuner de sortie en sortie du DST pour maximiser la puissance de sortie. L'optimisation résulte de la maximisation du gain en puissance transducique.

Les tuners d'entrée et de sortie sont des tuners mécaniques pilotés par des moteurs pas à pas et pour effectuer une recherche automatique des conditions optimales d'adaptation. Ils sont pré-calibrés et, pour chaque réglage, une mémoire intégrée permet de connaître les pertes et les impédances de ces tuners vis-à-vis des signaux et micro-ondes utilisés.

Lorsque les coupleurs d'entrée 10, 12 et de sortie 22, 24, sont en configuration avale du tuner d'entrée 14 et de sortie 16 (Figure 1b), les impédances sont mesurées - en module et phase - en entrée et en sortie du DST par un analyseur de réseaux vectoriel 20. Cet analyseur est connecté au banc B par les coupleurs d'entrée, 10 et 12, et par des coupleurs de sortie, 22 et 24, au moyen de voies couplées incidentes et réfléchies, respectivement V1 et V3, V2 et V4.

Après calibrage, l'analyseur de réseaux vectoriel 20 permet alors de déduire la puissance incidente, la puissance réfléchie en entrée du DST ainsi que la puissance de sortie délivrée à la charge. En configuration amont, cette puissance est mesurée par un bolomètre 17 en sortie du tuner 16.

Les techniques évoquées sont utiles lorsque le DST est soumis directement à un signal de puissance en provenance de la source 1, car le niveau de puissance appliqué influence alors la détermination des impédances optimales.

Mais ces techniques de tests ne sont plus utiles lorsque le DST est dans un régime de fonctionnement linéaire :

dans ce cas, la détermination des conditions peut être effectuée à partir de mesures en faible signal en termes de puissance par un formalisme connu de type paramètres S.

Par rapport à la configuration amont, la configuration avale permet de s'affranchir d'une calibration préalable délicate des tuners, les valeurs d'impédances étant directement connues par l'analyseur de réseau vectoriel 20. Le calibrage des tuners est délicat car il est lié à la répétabilité mécanique des éléments mobiles du tuner, et à la stabilité mécanique du montage effectué pour le test.

Le problème principal est lié aux pertes du circuit présent entre le DST et les tuners. En effet, il est parfois nécessaire de placer des dispositifs entre ces deux éléments, comme des adaptateurs, des câbles ou des Tés de polarisation, 3 et 4 (cf Figures 1 a et 1 b) permettant de coupler un signal continu et un signal alternatif. Ces derniers éléments sont nécessaires quand le DST ne possède pas de circuits de polarisation internes. L'alimentation du DST en énergie se fait alors par le biais de ces circuits de polarisations externes.

La configuration avale présente l'inconvénient majeur d'augmenter les pertes de signal entre les tuners et le DST, du fait de la présence des coupleurs de mesures : la zone d'impédances pouvant être exploitée est alors sensiblement réduite dans le plan du DST car, du fait des pertes d'énergie supplémentaires dans ces éléments, les impédances dites optimales ne peuvent pas toujours être synthétisées. De manière générale, plus les pertes d'énergies sont importantes entre le tuner et le DST, plus la zone d'impédances pouvant être synthétisée est restreinte. Il en résulte alors une méconnaissance des performances optimales du DST car l'optimisation réalisée à l'aide de tuners n'est pas maximisée.

Le document WO 2005/121817 décrit une analyse et caractérisation de dispositif en temps réel.

Ces pertes limitent donc la gamme d'impédances pouvant être présentée. Ceci est lié aux pertes d'énergies dans les Tés de polarisation, les coupleurs, les câbles ou adaptateurs situés entre le DST et les tuners d'impédances.

Afin de remédier à ce problème, il a été proposé d'utiliser des tuners capables de synthétiser intrinsèquement une large gamme d'impédances, soit en améliorant les caractéristiques mécaniques des tuners, soit en associant ces deniers avec des éléments électroniques actifs. Le document de brevet US 7053628 évoque ce type de moyens.

Une autre solution consiste à placer entre le DST et les tuners des circuits ayant les pertes les plus faibles possibles, comme décrite dans le document de brevet US 2003107363 ou US 6414563.

Ces solutions ne permettent pas de résoudre le problème ci-dessus avec satisfaction.

L'invention vise à mettre en oeuvre une technique de type « source pull » qui permet de résoudre ledit problème en s'affranchissant de la limitation imposée par la synthèse d'impédance de source, en utilisant une technique de mesure permettant même de s'affranchir de l'usage d'un tuner en entrée du DST.

Contrairement aux bancs de mesures classiques, l'impédance de source est définie selon l'invention de manière théorique, et non de manière physique. A partir de cette impédance de source théorique, il est possible de calculer la puissance disponible théorique qui serait délivrée par cette source. Cette invention repose sur le postulat que le DST est parfaitement unilatéral, à savoir que l'impédance de source présentée n'influe pas sur l'impédance de sortie présentée par le DST.

Une approche théorique succinte appartenant à l'arrière plan de l'invention est abordée de manière succincte dans le brevet WO2005121817. Cependant, l'auteur ne mentionne que très brièvement les bénéfices de cette approche, et ne commente pas le pas le fait que celle ci n'est valide que si le DST est parfaitement unilatéral.

A partir du postulat de parfaite unilatéralité du DST, l'esprit de l'invention présentée ici diffère du fait qu'elle consiste à calculer, et non pas à fixer de manière arbitraire, la puissance disponible équivalente que délivrerait une source d'impédance interne donnée et exprimée sous sa forme complexe.

Plus précisément, l'invention a pour objet un procédé de détermination d'impédance de source optimale en entrée d'un dispositif sous test (DST) dans un banc de mesure, comportant les étapes de :

- calibrage d'un banc de type source pull comme banc de mesure,
- réglage d'une impédance de charge et polarisation continue du DST,
- génération d'un signal électrique de puissance par la source et injectée dans le DST,
- acquisition d'impédances d'entrée du DST et de performances de gain correspondant,

dans lequel :

- une impédance de source définie de manière théorique est ajustée sur une impédance d'entrée du DST mesurée,
- une acquisition de performances de gain en puissance transducique pour l'impédance de source est déterminée en fonction de l'impédance de source définie de facon théorique, de la mesure de l'impédance de charge du DST, ainsi que de la mesure de la puissance nette injectée en entrée du DST et de la puissance de sortie du DST,
- un écart des performances en fonction des désadaptations calculées entre l'impédance de source théorique et l'impédance d'entrée mesurée du DST est déterminé, et
- dans le cas où l'écart est supérieur à une valeur de référence, au moins une nouvelle impédance source est définie théoriquement jusqu'à obtenir de manière itérative un écart inférieur à la valeur de référence, et les performances de gain transducique du DST à partir de cette impédance de source sont alors déterminées.

Une fois ce cycle terminé pour une première impédance de charge donnée, une nouvelle impédance de source peut ensuite être définie théoriquement pour une nouvelle impédance de charge ou un autre DST en reprenant le cycle précédent.

La présente solution élimine les limitations physiques pouvant restreindre la détermination des performances obtenues dans des conditions de fonctionnement optimales du fait de l'utilisation de moyens permettant de simuler des moyens physiques, à savoir le tuner d'entrée. Dans cette configuration, les pertes de signal entre le coupleur et le DST ne sont plus un problème. Une gamme étendue de résultats est à présent accessible, tels que ceux qui seraient obtenus avec un coupleur de mesure en entrée sans perte.

Un autre avantage est de s'affranchir de la nécessité d'effectuer une mesure pour une impédance de source donnée, afin de connaître les performances du DST pour cette dite impédance de source. Par exemple, si l'utilisateur voulait connaître les performances obtenues pour X impédances de source différentes, il fallait réaliser X mesures en changeant à chaque fois cette impédance de source.

De plus, une fois les mesures effectuées, il est difficile de connaître *a posteriori* les résultats qui auraient été obtenus pour d'autres impédances de sources. Certains paramètres sont en effet assez sensibles à la variation de l'impédance de source, comme l'expansion de gain transducique en fonction du niveau de puissance. Pour des conditions de fonctionnement données, l'expansion de gain transducique correspond à l'augmentation du gain transducique en fonction de la puissance d'entrée disponible jusqu'à une valeur limite au-delà de laquelle le gain décroit.

Des méthodes d'interpolations basiques ne peuvent donc pas être utilisées avec un degré élevé de confiance. Un autre avantage de l'invention est donc de pouvoir utiliser *a posteriori* les résultats obtenus pour en extraire de nouveaux à partir de nouvelles valeurs simulées d'impédances de sources sans refaire de nouvelles mesures.

L'invention permet également de définir les conditions optimales de fonctionnement du transistor en fonction de plusieurs paramètres, qui peuvent être le gain en puissance transducique, la compression de gain, le rendement de puissance. Une acquisition de performances de chaque paramètre pour l'impédance de source est déterminée en fonction de l'impédance de source théorique, de l'impédance de charge mesurée du DST, ainsi que de la puissance nette injectée en entrée et de la puissance de sortie mesurée dans les plans de référence du DST. L'optimisation cyclique est alors réalisée comme décrit précédemment en tenant compte non pas d'une, mais de plusieurs valeurs de références propres à chaque grandeur mesurée.

L'invention se rapporte également à un système de détermination d'impédance de source optimale en entrée d'un DST comportant un banc de mesure de type « source pull » calibré, dans lequel ce banc détermine des valeurs d'impédances de source théoriques, et des valeurs d'impédances d'entrée du DST mesurées, pour mettre en oeuvre le procédé précédent, à l'aide d'un analyseur de réseaux vectoriel, des valeurs de puissances d'entrée et de sortie du DST à l'aide de coupleurs disposés respectivement en entrée et en sortie du DST.

D'autres caractéristiques et avantages de l'invention apparaîtront à la lecture de l'exemple de réalisation qui suit, en référence aux dessins annexés qui représentent, respectivement :

- Figure 1a, le schéma de banc de mesure classique en mode source/load pull en configuration amont (déjà commentée);
- Figure 1b, le schéma de banc de mesure classique en mode source/load pull en configuration avale (déjà commentée) ;
- Figure 2, un exemple de schéma de banc de mesure utilisé pour mettre en oeuvre l'invention ;
- Figure 3, un graphique comparatif représentant les courbes de gain transducique d'un transistor, obtenues pour huit impédances de source mesurées ou données de manière théorique suivant le procédé de l'invention, et
- Figure 4, un organigramme des principales étapes du procédé selon l'invention.

Dans les figures, une même référence désigne un élément identique.

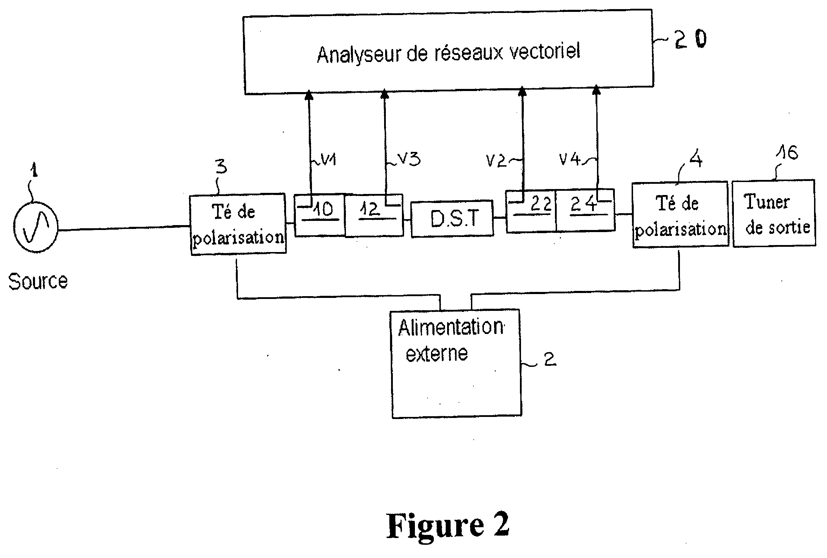

Le banc de mesures illustré en figure 2 est un banc de source pull aval qui diffère du banc illustré en figure 1b par l'absence de tuner d'entrée 14 (figure 1 b). Cette absence implique une désadaptation physique entre la source 1 et le DST à tester en entrée, mais cette désadaptation est indépendante de la détermination des conditions optimales et les résultats correspondants obtenus selon l'invention par une simulation d'adaptation du DST.

Le DST est, dans cet exemple, un transistor à effet de champ. La fréquence fondamentale f0 de test est de 4GHz. L'impédance de charge fondamentale $Z_L$ présentée en sortie du DST est de 81,3+J51,6 Ohms. Grâce à l'utilisation d'un tuner 16 de charge multi-harmonique en sortie, les impédances harmoniques aux fréquences 2f0 et 3f0 sont réglées sur 50 $\Omega$. La polarisation continue du DST est égale à Vgs0 = -0,68V à gauche, Vds0 = 7V à droite et Ids0 = 30mA en intensité.

Les grandeurs mesurées à la fréquence fondamentale f0 sont :

- la puissance $P_{OUT}$ en sortie de DST, égale à 953 $\mu$W, mesurée par les coupleurs de sortie 22 et 24,
- la puissance nette injectée « $P_{IN}$ » dans le DST, égale à 2,17 $\mu$W, et
- l'impédance de charge « $Z_L$ » du DST qui vaut 2,3 - J31,17 $\Omega$, les valeurs $P_{IN}$ et $Z_L$ étant fournies par l'analyseur de réseaux vectoriel 20.

Ces grandeurs sont indépendantes de l'impédance de source choisie de manière théorique.

La puissance disponible dans le plan d'entrée du DST est, par calcul, la puissance $P_{AV}$ délivrée par un générateur équivalent à la source 1 d'impédance interne théorique $Z_G$ qui diffère de 50 $\Omega$, valeur de référence couramment utilisée dans les applications de mesures radio et hyperfréquences.

La valeur de la puissance d'entrée disponible calculée $P_{AV}$ se déduit des valeurs de puissance d'entrée nette « $P_{IN}$ », de l'impédance d'entrée « $Z_{IN}=R_{IN}+jX_{IN}$ » (mesurée) et « $Z_G=R_G+jX_G$ » (donnée), par le calcul intermédiaire de la force électromotrice Eg du générateur équivalent, sans qu'il soit besoin de mettre en place physiquement une telle impédance pour en effectuer la mesure, afin de s'affranchir de toute imprécision et de toute limitation de gamme de valeurs générées par un tuner d'entrée.

$$E_G^2 = 2\frac{P_{IN}}{R_{IN}}[(R_G + R_{IN})^2 + (X_G + X_{IN})^2] \quad \text{(eq.1)}$$

$$P_{AV} = \frac{1}{8}\frac{|E_G|^2}{R_G} \quad \text{(eq.2)}$$

Pour chaque valeur d'impédance $Z_G$ donnée, la valeur du gain en puissance transducique se déduit alors directement du rapport $P_{OUT}/P_{AV}$ entre la puissance de sortie $P_{OUT}$ délivrée à la charge et la puissance disponible calculée $P_{AV}$ dépendant de l'impédance $Z_G$, correspondant à l'impédance de source interne du générateur équivalent.

D'autres caractéristiques du DST associées à un environnement donné, tel que le rendement en puissance, la compression ou l'expansion de gain, peuvent également être déduites par le calcul.

En déterminant, *a posteriori,* les résultats obtenus pour une autre impédance de source, il est alors avantageux de pouvoir atteindre plusieurs objectifs simultanés - par exemple une puissance de sortie donnée associée à une compression de gain transducique maximale -, alors que la méthode de test traditionnelle nécessite la mesure du gain en puissance transducique pour chaque impédance de source synthétisée par le tuner de source. Pour mémoire, la compression de gain transducique est l'écart entre le gain transducique mesuré pour un niveau de puissance donné et la valeur du gain transducique maximal obtenu sur toute la plage de variation de puissance.

Ainsi, en utilisant la méthode selon l'invention, les valeurs de gain transducique sont déterminées pour toute impédance de source définie de manière théorique, alors que la méthode classique nécessite autant de mesures que d'impédances de source différentes.

Traditionnellement, la méthode classique nécessite de synthétiser X, par exemple huit, impédances de sources différentes par le tuner de source pour mesurer le gain en puissance transducique et mettre en oeuvre X caractérisations différentes.

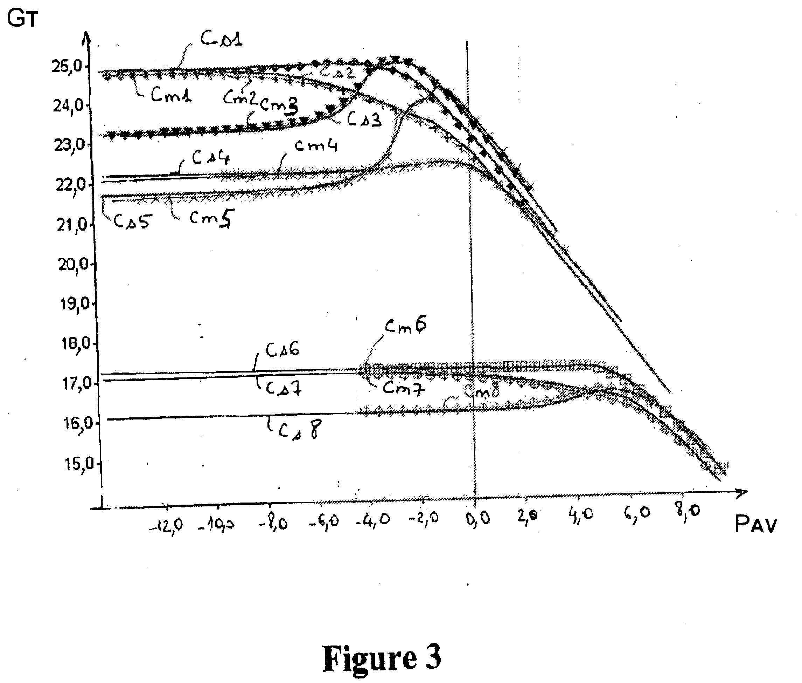

La figure 3 illustre un graphique comparatif entre :

- les courbes construites par points à l'aide d'une méthode classique, Cm1 à Cm8, du gain en puissance transducique Gt du transistor testé, en fonction d'un balayage de puissances disponibles Pav mesurées en entrée du DST , et
- les courbes lisses simulées Cs1 à Cs8 de ce gain en puissance transducique calculées par la méthode de calcul illustrée ci-dessus et reproduite pour différentes puissances disponibles.

A titre d'exemple, ces courbes sont obtenues pour huit impédances de source, soit synthétisées (Zs1 à Zs8) selon la méthode classique, soit données de manière théorique ($Z_{G1}$ à $Z_{G8}$) selon le procédé de l'invention. Dans cet exemple, pour chaque courbe, chaque impédance de source $Z_G$ correspond à la valeur de l'impédance de source $Z_S$ mesurée lors de l'utilisation du banc source pull classique.

Les courbes par points Cm1 à Cm8 et simulées Cs1 à Cs8, qui retracent l'allure du gain en puissance transducique Gt en fonction du niveau de puissance, se superposent sensiblement pour chacune des 8 impédances de source.

Ainsi il apparaît que la méthode utilisée permet de reproduire de manière calculée les valeurs de gain transducique mesuré obtenues sur tout le balayage de puissances pour les huit impédances des source synthétisées. Il est alors justifié d'appliquer cette méthode de calcul pour d'autres gammes d'impédance et pour tout type de caractéristiques du DST .Cette technique peut être appliquée rigoureusement pour obtenir des résultats lorsque l'impédance de source ne joue que sur les conditions d'adaptation en entrée du DST. Si l'impédance de source influe également sur le fonctionnement intrinsèque du DST, cette technique ne constitue alors qu'un outil d'approximation, mais fournissant des résultats relativement fiables

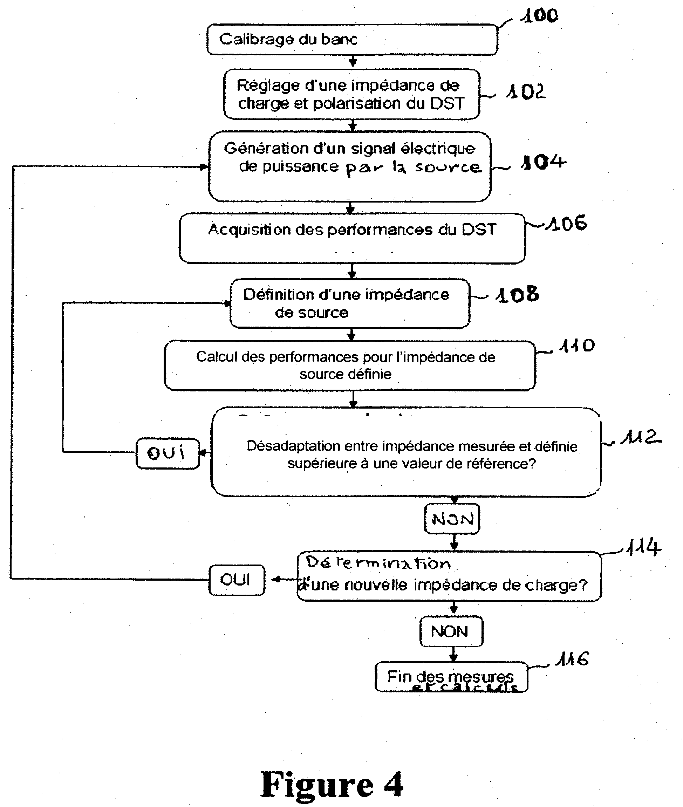

L'organigramme illustré en figure 4 reprend les différentes phases du procédé selon l'invention :

- calibrage 100 d'un banc de type source pull en configuration avale comme banc de mesure,
- réglage 102 d'une impédance de charge $Z_L$ et polarisation continue du DST,
- génération 104 d'un signal électrique de puissance injectée $P_{IN}$ par la source dans le DST,
- Acquisition 106 des performances de gain en puissance dans un environnement de mesures correspondant aux impédances de sources Zs (Zs1 à Zs8 dans l'exemple) présentées en entrée du DST et,

dans lequel :

- une impédance de source donnée $Z_G$ est ajustée sur une impédance d'entrée mesurée $Z_{IN}$ (étape 108),
- Un calcul 110 des performances de gain en puissance transducique Gt pour l'impédance de source donnée $Z_G$ est déterminée en fonction de cette impédance de source donnée $Z_G$, de l'impédance d'entrée $Z_{IN}$ du DST, de la puissance disponible délivrée par le générateur équivalent $P_{AV}$, exprimée par l'intermédiaire de la force électromotrice Eg de ce générateur, et de la puissance de sortie $P_{OUT}$ du DST.

Pour chaque niveau de puissance nette injectée $P_{IN}$ délivrée par la source, un calcul de désadaptation entre l'impédance d'entrée du DST $Z_{IN}$ telle que mesurée et l'impédance de source donnée $Z_G$ est effectué. Ce calcul fournit alors toutes les données nécessaires pour calculer des grandeurs telles que le gain en puissance transducique, le rendement en puissance transducique, ou encore la puissance disponible $P_{AV}$ du générateur équivalent dans le plan d'entrée du DST en fonction de l'impédance de source adoptée.

Un écart des performances en fonction de désadaptations entre l'impédance de source simulée et les impédances d'entrée synthétisée est donc déterminé (étape 112).

Dans le cas où l'écart est supérieur à une valeur de référence fixée librement par l'utilisateur, au moins une nouvelle impédance source $Z_G$ est définie par bouclage sur l'étape 108 jusqu'à obtenir de manière itérative un écart inférieur à la valeur de référence, et les performances de gain du DST à partir de cette impédance de source simulée sont alors déterminées.

Une fois ce cycle terminé pour une première impédance de charge donnée, une nouvelle impédance de charge peut ensuite être déterminée (étape 114 et rebouclage sur l'étape 104) pour une nouvelle impédance de charge en reprenant le cycle de simulation précédent. Les mesures et calculs sont terminés lorsque l'ensemble des impédances de charge ont été analysées (étape 116).

L'invention n'est pas limitée aux exemples décrits et représentés. Ainsi, une variante de la méthode proprosée serait de mesurer l'impédance d'entrée du DST en utilisant une autre méthode que celle décrite précédemment, et de recalculer *a posteriori* la désadaptation entre l'impédance d'entrée du DST mesurée et l'impédance de source théorique adoptée

Par exemple, l'impédance d'entrée du DST est mesurée ci-dessus avec un analyseur de réseaux vectoriel connecté sur un coupleur de mesure externe en entrée du DST. Mais la mesure de l'impédance d'entrée du DST peut également être effectuée à partir d'autres instruments de mesures susceptibles de mesurer une impédance complexe en module et en phase, dans le domaine fréquentiel ou temporel.

Il est ainsi possible de mesurer l'impédance d'entrée du DST avec différents instruments de mesures, ou différents type de montage. Par exemple l'impédance d'entrée d'un DST peut être mesurée à partir de mesures faites au moyen d'un analyseur de réseau vectoriel au travers d'un tuner de source pré-calibré. En effet, connaissant les caractéristiques de ce tuner, à partir d'une mesure faite en amont dudit tuner, il est possible par calcul de remonter à l'impédance vue en aval du tuner. Il a été montré que l'invention permet de s'affranchir des limites physiques du tuner d'entrée, voire de se passer complètement de ce tuner.

Cependant, la connaissance théorique des performances optimales n'empêche pas de se rapprocher physiquement de ces conditions par la présence d'un tuner de source, afin d'utiliser un niveau de signal de source inférieur car la réflexion du signal est alors minimisée par l'adaptation physique.

Par ailleurs, l'invention peut s'appliquer si l'utilisation de coupleurs mesurant les puissances incidentes et réfléchies aux accès du DST et remplacée par tout type de dispositifs permettant de mesurer ces grandeurs.

Ainsi, connaissant l'impédance de source optimale théorique grâce à l'invention, le tuner de source peut être utilisé pour s'approcher au mieux des conditions d'adaptation optimales en limitant la quantité de signal physiquement réfléchi en entrée du DST lors des tests. Sinon, en absence de tuner, une majorité de puissance est réfléchie en entrée du DST, et il convient alors d'utiliser un niveau de signal de source plus important pour conduire les tests.

Un des principaux avantages de l'invention est donc de supprimer les limitations de tests conduisant à la détermination des conditions réellement optimales, avec ou sans tuner de source, afin de pouvoir effectuer du post-processing avec souplesse.

Par ailleurs, le formalisme utilisé pour calculer la désadaptation entre une impédance d'entrée mesurée et une impédance de source simulée est basé sur l'utilisation de générateur équivalent. Les calculs décrits utilisent des variables représentant des tensions, courants et impédances. Un autre formalisme peut être utilisé en employant par exemple des ondes de puissances définies par rapport une impédance de référence. L'utilisation de ce même formalisme ne conduit alors qu'à la réécriture des mêmes équations basées sur l'utilisation d'autres variables.

De plus, la présente invention employant des résultats de mesures associés à une méthode de calcul peut être indifféremment utilisée au sein d'un tableur, d'un logiciel ou autre outils numériques.

## Revendications

1. Procédé de détermination d'impédance de source optimale en entrée d'un dispositif sous test (DST) dans un banc de mesure, il comporte les étapes de :

   - calibrage d'un banc de type source pull comme banc de mesure,
   - réglage d'une impédance de charge et polarisation continue du DST,
   - génération d'un signal électrique de puissance par la source et injectée dans le DST,
   - acquisition d'impédances d'entrée du DST et de performances de gain transducique correspondant,

   **caractérisé en ce qu'**il comporte les étapes:

   - une impédance de source définie théoriquement est ajustée sur une impédance d'entrée du DST mesurée,
   - une acquisition de performances de gain en puissance transducique est déterminée en fonction de l'impédance de source définie de manière théorique, de l'impédance d'entrée mesurée dans le plan du DST, ainsi que de la puissance nette injectée en entrée du DST et de la puissance de sortie du DST,
   - un écart des performances en fonction de désadaptations simulées entre l'impédance de source définie théoriquement et les impédances d'entrée du DST est déterminé, et
   - dans le cas où l'écart est supérieur à une valeur de référence, au moins une nouvelle impédance source est définie jusqu'à obtenir de manière itérative un écart inférieur à la valeur de référence, et les performances de gain transducique du DST à partir de cette impédance de source sont alors déterminées.

2. Système de détermination d'impédance de source optimale en entrée d'un DST comportant un banc de mesure de type « source pull » calibré, dans lequel ce banc détermine des valeurs d'impédances d'entrée simulée, de mise en oeuvre du procédé selon la revendication 1, à l'aide d'un analyseur de réseaux vectoriel, des valeurs de puissances d'entrée et de sortie du DST à l'aide de coupleurs disposés respectivement en entrée et en sortie du DST.

3. Système de détermination d'impédance de source optimale selon la revendication 2, dans lequel le banc comporte un tuner d'entrée de source.

## Patentansprüche

1. Verfahren zur Bestimmung der optimalen Quellenimpedanz am Eingang einer zu prüfenden Vorrichtung (DST) auf einer Prüfbank, umfassend die folgenden Schritte:

   - Kalibrieren einer Bank vom Typ Source-Pull als Prüfbank,
   - Einstellen einer Lastimpedanz und kontinuierliche Polarisierung der DST,
   - Erzeugen eines elektrischen Leistungssignals durch die Quelle und injiziert in die DST,
   - Emfangen von Eingangsimpedanzen der DST und Leistungen der entsprechenden Wandlerverstärkung,

   **dadurch gekennzeichnet, dass** es die folgenden Schritte umfasst:

   - eine theoretisch definierte Quellenimpedanz wird auf eine gemessene Eingangsimpedanz der DST eingestellt,
   - ein Empfang von Leistungen der entsprechenden Wandlerkraftverstärkung wird auf Grundlage der theoretisch definierten Quellenimpedanz, der auf der Ebene der DST gemessenen Eingangsimpedanz, sowie der Nettoleistung, die am Eingang der DST injiziert wird, und der Leistung am Ausgang der DST bestimmt,
   - eine Abweichung der Leistungsfähigkeit auf Grundlage der simulierten Fehlanpassungen zwischen der theoretisch definierten Quellenimpedanz und den Eingangsimpedanzen der DST wird bestimmt, und
- für den Fall, dass die Abweichung größer als ein Referenzwert ist, wird mindestens eine neue Quellenimpedanz definiert, bis iterativ eine geringere Abweichung als der Referenzwert erhalten wird, und die Leistungen der Wandlerverstärkung der DST ausgehend von dieser Quellenimpedanz werden nun bestimmt.

2. System zur Bestimmung der optimalen Quellenimpedanz am Eingang einer DST, umfassend eine kalibrierte Prüfbank vom Typ "Source-Pull", wobei diese Bank Werte von simulierten Eingangsimpedanzen zur Durchführung des Verfahrens nach Anspruch 1 mit Hilfe eines Vektor-Netzwerkanalysators, der Werte von Eingangs- und Ausgangsleistungen der DST mit Hilfe von Kopplern bestimmt, die jeweils am Eingang und am Ausgang der DST angeordnet sind.

3. System zur Bestimmung der optimalen Quellenimpedanz nach Anspruch 2, wobei die Bank einen Quelleneingangstuner umfasst.

**Claims**

1. Method for determining optimal source impedance at an input of a device under test (DUT) in a measurement bench, it comprises the following steps:

    - calibration of a source pull type bench as a measurement bench,
    - adjustment of a load impedance and continuous polarisation of the DUT,
    - generation of an electric power signal by the source and injected in the DUT,
    - acquisition of input impedances of the DUT and corresponding transducer gain performances,

    **characterised in that** it comprises the following steps:

    - a theoretically-defined source impedance is adjusted over an input impedance of the DUT measured,
    - a transducer power gain performance acquisition is determined based on the source impedance theoretically defined, the input impedance measured in the plane of the DUT, as well as the net power injected at the DUT input and the output power of the DUT,
    - a deviation is determined in the performances based on simulated mismatchings between the theoretically-defined source impedance and the input impedances of the DUT, and
    - in the event that the deviation is greater than a reference value, at least one new source impedance is defined until iteratively obtaining a deviation less than the reference value, and the transducer gain performances of the DUT based on this source impedance are thus determined.

2. System for determining optimal source impedance at an input of a DUT comprising a calibrated "source pull" type measurement bench, wherein this bench determines simulated input impedance values, for implementing the method according to claim 1, using a vector network analyser, of the input and output power values of the DUT using couplers respectively positioned at the input and output of the DUT.

3. System for determining optimal source impedance according to claim 2, wherein the bench includes a source input tuner.

**Figure 1a**

EP 2 264 473 B1

**Figure 1b**

**Figure 2**

**Figure 3**

*100* Calibrage du banc

*102* Réglage d'une impédance de charge et polarisation du DST

*104* Génération d'un signal électrique de puissance par la source

*106* Acquisition des performances du DST

*108* Définition d'une impédance de source

*110* Calcul des performances pour l'impédance de source définie

*112* Désadaptation entre impédance mesurée et définie supérieure à une valeur de référence?

OUi

NON

*114* Détermination d'une nouvelle impédance de charge?

OUI

NON

*116* Fin des mesures et calculs

**Figure 4**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7248866 B
- CA 2558861
- CA 2549698
- WO 2005121817 A
- US 7053628 B
- US 2003107363 A
- US 6414563 B